Europäisches Patentamt

European Patent Office

Office européen des brevets

(19)

(11) **EP 1 589 065 A1**

(12) **EUROPEAN PATENT APPLICATION**

(43) Date of publication:
26.10.2005 Bulletin 2005/43

(51) Int Cl.⁷: **C08K 3/22**, H01B 3/00,
H05K 1/03

(21) Application number: 05008752.7

(22) Date of filing: 21.04.2005

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: 21.04.2004 JP 2004125886

(71) Applicant: **TDK Corporation**
**Tokyo 103-8272 (JP)**

(72) Inventors:
• **Kanada, Isao**
**Tokyo 103-8272 (JP)**
• **Sakamoto, Norimasa**
**Tokyo 103-8272 (JP)**

(74) Representative: **HOFFMANN EITLE**
**Patent- und Rechtsanwälte**
**Arabellastrasse 4**
**81925 München (DE)**

(54) **Method for producing dielectric ceramic powder and method for producing composite dielectric material**

(57)    A method for producing a dielectric ceramic powder which can secure fluidity of the mixture thereof with a resin, even when produced by milling, is provided. A composite dielectric material which secures, the fluidity of the mixture thereof with a resin and is excellent in dielectric properties can be obtained on the basis of the method for producing a dielectric ceramic powder, comprising a first firing step for firing a starting material at a first temperature to obtain a first fired substance; a first milling step for milling the first fired substance to obtain a first milled substance; a second firing step for firing the first milled substance at a second temperature lower than the first temperature to obtain a second fired substance; and a second milling step for milling the second fired substance to obtain a second milled substance.

EP 1 589 065 A1

Printed by Jouve, 75001 PARIS (FR)

## Description

BACKGROUND OF THE INVENTION

Field of the Invention

The present invention relates to a dielectric ceramic powder, in particular, a dielectric ceramic powder which can exhibit excellent properties when formed into a composite substrate together with an organic resin material.

Description of the Related Art

Recently, reduction in size and weight, and speedup of communication appliances are eagerly demanded. Particularly, the frequency band of the radio waves, for use in the cellular mobile communication such as digital cellular phones, and in the satellite communication falls in a high frequency band ranging from the megahertz band to the gigahertz band (hereinafter, referred to as "GHz band").

In the rapid development of the communication appliances being used, downsizing and high density mounting have been attempted for the cases, substrates, and electronic elements. For the purpose of further promoting the reduction in size and weight of the communication appliances for the high frequency bands, the materials for the substrates and the like used in communication appliances are required to be excellent (small in dielectric loss) in high frequency transmission properties in the GHz band.

The dielectric loss is proportional to the product of the frequency, the square root of the dielectric constant $\varepsilon$ of the substrate (hereinafter, represented by $\varepsilon^{0.5}$) and the dielectric dissipation factor (hereinafter, represented by $\tan\delta$). Accordingly, for the purpose of reducing the dielectric loss, it is necessary to reduce the $\tan\delta$ of the substrate. In addition, the wavelength of an electromagnetic wave is contracted in a substrate by a factor of $1/\varepsilon^{0.5}$, and hence the larger is the dielectric constant $\varepsilon$, the substrate size can be made the smaller.

From the above, the circuit boards for the downsized communication appliances, electronic appliances, and information appliances used in a high frequency band are required to have such material properties that the dielectric constant $\varepsilon$ is high and also Q value (here, Q is the reciprocal of $\tan\delta$, Q = $1/\tan\delta$) is high.

As the materials used for such circuit boards, dielectric ceramics are used as inorganic materials, while fluororesins and the like are used as organic materials. The substrates made of dielectric ceramics are excellent in the properties of dielectric constant $\varepsilon$ and Q value, but have drawbacks in dimension accuracy and machinability, and have a problem that the dielectric substrates are so brittle that they are easily chipped and cracked. On the other hand, the substrates made of organic materials such as resins and the like have the advantages of excellent moldability and machinability, and high Q value, but have a problem that the dielectric constants $\varepsilon$ are small. Accordingly, recently, for the purpose of obtaining substrates simultaneously having both advantages thereof, composite substrates have been proposed which are formed as composite substances of organic materials and inorganic materials by mixing dielectric ceramic powders in organic resin materials (for example, see Japanese Patent No. 2617639).

Accompanying the advent of such composite substrates, those dielectric materials which are excellent in dispersion properties and packing properties for organic resin materials are demanded. A factor for a dielectric powder to acquire the dispersion properties and packing properties for organic resin materials is the particle size of the powder. For example, powders produced from the liquid phase by employing a precipitation method, are too fine to acquire the dispersion properties and packing properties for organic resinmaterials.

In addition, another factor for powders to acquire the dispersion properties and packing properties for organic resin materials is the particle shape.

In JP-A 2003-151352, the applicant of the present invention has proposed spherical dielectric powder wherein a sphericity of 0.82 to 1 and the ratio between the 10% diameter and the 90% diameter of the powder is 30 or less, to be dispersed in an organic resin material. Particles close to true spheres, i.e., those having a sphericity of 0.82 to 1, greatly improve their dispersion and packing properties in an organic resin material to give a composite dielectric material of excellent high-frequency properties. JP-A 2003-151352 also discloses that dielectric ceramic particles of narrow particle size distribution and high sphericity allow the mixture with an organic resin material, i.e., composite dielectric material, to be packed even in the substrate pattern edges.

The dielectric ceramic powder disclosed in JP-A 2003-151352 is produced by supplying the granular powders into a combustion flame, in which they are melted when stayed for a given time and formed into spheres after being cooled. Milling is another method for producing dielectric ceramic powder. This method essentially comprises milling of the fired starting material by jet mill or the like into fine particles. The particles produced by milling have an advantage that the production cost is low, but they an indefinite shape, and are anticipated to deteriorate fluidity of the mixture with an organic resin material. A composite dielectric substrate is formed by pressing the sheet of a mixture of dielectric ceramic powder and resin material under heating. The mixture (or resin) for a substrate may not give an accurate electrical circuit pattern on the substrate when it is not sufficiently fluid during the above pressing, because of difficulty in flowing into edges in the pattern.

SUMMARY OF THE INVENTION

The present invention has been developed to solve these technical problems. It is an object of the present invention to provide a method for producing dielectric ceramic powder which can secure fluidity of a mixture thereof with a resin, even when produced by milling. It is another object of the invention to provide a composite dielectric material comprising a resin and the above dielectric ceramic powder as a filler.

First, fluidity of a mixture of dielectric ceramic powder and a resin is studied, where the resin is normally a thermosetting resin for a composite dielectric substrate. When the mixture is heated from room temperature, the resin therein decreases in viscosity. Resin decreases in viscosity simply with temperature to a certain level, but turns to increase when temperature reaches its curing temperature. Fluidity is evaluated as the lowest viscosity (lowest melt viscosity) during the thermosetting process. It is found that powder specific surface area affects the lowest melt viscosity.

It is meaningless when the mixture with increased fluidity deteriorates in dielectric properties (dielectric constant $\varepsilon$ and Q value) . It is found that a dielectric ceramic powder deteriorates in dielectric properties, in particular Q value, depending on its lattice strain, even when the composition is kept constant.

Specifically, a dielectric ceramic powder having a specific surface area of 9 m$^2$/cm$^3$ or less and lattice strain of 0. 2 or less can secure fluidity of the mixture with a resin, even when it is produced by milling to have particles of indefinite shape.

Additionally, it has been verified that a dielectric ceramic powder having a specific surface area of 9 m$^2$/cm$^3$ or less and a lattice strain of 0.2 or less can be obtained by repeating twice or more times the firing step and the milling step; and that the reactions involving the respective constituent elements can be accelerated by setting the temperature of the first firing step to a temperature higher than the temperatures of the subsequent firing steps, and consequently the dielectric properties of the thus obtained dielectric ceramic powder and accordingly those of the composite dielectric material can be improved. Accordingly, the problems mentioned above can be solved by the present invention which is a method for producing a dielectric ceramic powder comprising a first firing step for firing a starting material by retaining the starting material at a first temperature to obtain a first fired substance; a first milling step for milling the first fired substance to obtain a first milled substance; a second firing step for firing the first milled substance by retaining the first milled substance at a second temperature lower than the first temperature to obtain a second fired substance; and a second milling step for milling the second fired substance to obtain a second milled substance. The starting material to be fired in the first firing step may be a calcined substance obtained by calcining a mixture of raw material powders can be used, or the first firing may double as the calcination. In the latter case, the starting material to be fired in the first firing may be a mixture of raw material powders.

In the method for producing a dielectric ceramic powder of the present invention, the first temperature in the first firing step is preferably 1300 to 1650°C, and the second temperature in the second firing step is preferably 1100 to 1300°C, for the purpose of achieving the effect of the present invention. The first temperature and the second temperature may be appropriately selected from the above described ranges, principally depending on the material employed as the desired ceramics, as described later.

In the method for producing a dielectric ceramic powder of the present invention, the second milled substance can be used as a filler for a composite dielectric material. When the thickness of a composite dielectric substrate is thin, presence of large particles possibly makes the surface roughness higher, so that the largest particle size of the second milled substance is preferably 10 $\mu$m or less.

In the method for producing a dielectric ceramic powder of the present invention, it is preferable that the first milling step and the second milling step are conducted by use of a jet mill for the purpose of obtaining a predetermined specific surface area and a predetermined lattice strain.

In the method for producing a dielectric ceramic powder of the present invention, the second milled substance may be subjected to a third firing step to produce a third fired substance under the same conditions as in the second firing step, and the third fired substance can be milled to obtain a third milled substance. The present invention allows further execution of a fourth firing step based on the same conditions as in the second firing step, a fourth milling step, and so on.

The present invention provides a method for producing a composite dielectric material which incorporates the dielectric ceramic powder obtained by the present invention. The method for producing a composite dielectric material is a method for producing a composite dielectric material comprising a dielectric ceramic powder and an organic resin material for holding the dielectric ceramic powder therein, wherein the dielectric ceramic powder is produced through a first firing step for firing a starting material by retaining the starting material at a first temperature to obtain a first fired substance; a first milling step for milling the first fired substance to obtain a first milled substance; a second firing step for firing the first milled substance by retaining the first milled substance at a second temperature lower than the first temperature to obtain a second fired substance; and a second milling step for milling the second fired substance to obtain a second milled substance.

According to the method for producing a dielectric ceramic powder of the present invention, there can be obtained a dielectric ceramic powder which has a specific area of 9 m$^2$/cm$^3$ or less and a lattice strain of 0.2 or less, secures the fluidity of the mixture thereof with a resin to give excellent moldability for a substrate, and can provide high dielectric properties as a composite dielectricsubstrate. Additionally, by incorporating the dielectric ceramic powder, a composite dielectric material having high dielectric properties can be obtained. The composite dielectric material is excellent in fluidity, and accordingly can secure packing properties for pattern edges of composite dielectric substrates.

BRIEF DESCRIPTION OF THE DRAWINGS

FIG. 1 shows an X-ray diffraction pattern, by which a lattice strain of a powder prepared in the present invention is determined;
FIG. 2 is a graph, by which a lattice strain of a powder prepared in the present invention is determined;
FIG. 3 shows the firing conditions under which Samples Nos. 1 to 12 were prepared; and
FIG. 4 shows the powder properties of Samples Nos. 1 to 12 and the dielectric properties of composite dielectric materials incorporating Samples Nos. 1 to 12.

DETAILED DESCRIPTION OF THE PREFERRED EMBODIMENTS

The embodiments of the present invention are described.

The method for producing a dielectric ceramic powder of the present invention comprises at least two firing steps including a first firing step and a second firing step. The first firing step and the second firing step have different retention temperatures as described below.

In the first firing step, firing is carried out at a temperature higher than that in the second firing step for the purpose of making the mutual reactions between the components of the starting material proceed sufficiently. A preferable temperature range is from 1300 to 1650°C. When lower than 1300°C, the mutual reactions between the components of the starting material cannot be made to proceed sufficiently, and when exceeding 1650°C, there is a fear that the starting material is melted. The retention temperature is needed to be set depending on the material quality of desired ceramics. Appropriate temperature ranges for specific starting materials will be described later. The retention time in the first firing step preferably falls within a range from 0.5 to 10 hours. When less than 0.5 hour, no mutual reactions between the components of the starting material can be made to proceed sufficiently, and even when exceeding 10 hours, no further proceeding of the reactions can be expected.

The starting material is composed of a mixture of raw material powders in some cases, or calcined substance obtained by calcining raw material powders in some other cases.

When the starting material is composed of a mixture of raw materials, the starting material includes two or more compounds having different compositions. For example, when it is desired to obtain barium titanate, the starting material comprises BaCO$_3$ powder (a raw material powder) and TiO$_2$ powder (another raw material powder) respectively weighed to predetermined amounts, and moreover comprises additives in some cases. In the case of barium titanate, the purpose of the first firing step is to make the reaction between BaCO$_3$ powder and TiO$_2$ powder proceed sufficiently.

When the starting material is composed of calcined substances, it is possible that additives are added to the calcined substances, then the mixture thus obtained is milled, and the milled substance thus obtained is fired in the first firing step. The calcined substances can be obtained by retaining a mixture composed of two or more compounds having different compositions at a predetermined temperature.

The first fired substance obtained in the first firing step is milled (the first milling step). The firing temperature of the first firing step is high, so that the hardness of the first fired substance is high. Accordingly, the first milling step is lower in milling efficiency than the second milling step to be described later, and the first milled substance tends to be large both in specific surface area and in lattice strain. As shown in EXAMPLE described later, a first milled substance or a first milled substance comprising additives, obtained after the firing temperature has been set at 1300°C or higher, has a specific surface area exceeding 9 m$^2$/cm$^3$ and a lattice strain exceeding 0.2. Consequently, the first milled substance is not desirable as a filler as it is for composite dielectric materials. Then, in the present invention, the second milling step is carried out.

Even when the specific surface area exceeds 9 m$^2$/cm$^3$, and the lattice strain exceeds 0.2, repetition of one firing/milling cycle can make the specific surface equal to or less than 9 m$^2$/cm$^3$ and the lattice strain equal to or less than 0.2. This firing is the second firing. As shown in EXAMPLE described later, although two firing/milling cycles are enough, more than two cycles of firing/milling cycles may be carried out as described above.

It is necessary that the firing temperature in the second firing step be set to be lower than the firing temperature of the first firing step. More specifically, because the hardness of the first fired substance is high and, hence, it is necessary to supply a relatively large energy for milling the first fired substance, generation of an extremely finely milled powder tends to occur and the lattice strain of the milled powder also tends to become large. In the second firing step, the extremely finely milled powder is also once again fired to form the second fired substance. The second fired substance is fired at a temperature lower than that in the first firing step, so that the second fired substance can be milled with a relatively small energy. Consequently, the generation of the extremely finely milled powder is suppressed and the second milled substance with small lattice strain can be obtained. The retention temperature in the second firing step is preferably selected from a temperature range of from 1100 to 1300°C. If the retention temperature is lower than 1100°C, the firing is insufficient; while when the retention temperature exceeds 1300°C tomake the firing proceed in excess, the second fired substance comes to be hard. The difference between the first temperature and the second temperature is preferably 100°C or greater, more preferably 150°C or greater.

Additionally, the retention time in the second firing step may be of the same level as that in the first firing step; however, in the second firing step, it is not necessary to make any reaction proceed, and hence a shorter retention time than that in the first firing step is sufficient.

Next, the second fired substance obtained in the second firing step is milled (the second milling step). The second firing step is lower in temperature than the first firing step, and accordingly, the second fired substance can be more easily milled than the first fired substance. Consequently, the second milled substance can be made to have a specific surface area of 9 $m^2/cm^3$ or less and a lattice strain of 0.2 or less.

A milling machine may be selected from various ones for the first and second milling step. However, it is recommended to select an adequate one to secure a powder specific surface area of 9 $m^2/cm^3$ or less while keeping the largest particle size at 10 μm or less. The milled particles are not uniformly sized, and there exist ultra fine particles. They should have a larger specific surface area, when further milled. Therefore, it is recommended not to use a milling machine, such as ball mill, which repeatedly mills ultra fine particles. A jet mill is a desired select for the present invention. It generally has a classification capacity to control excessive milling of fine particles, and can easily produce the dielectric ceramic powder having a specific surface area of 9 $m^2/cm^3$ or less and the largest particle size of 10 μm or less. By contrast, when a ball mill is used, the largest particle size exceeds 10 μm when a specific surface area is 9 $m^2/cm^3$ or less and a specific surface area exceeds 9 $m^2/cm^3$ when the largest particle size is 10 μm or less. Of course, it is possible to remove ultra fine particles from the powder obtained after ball milling to make a specific surface area thereof be 9 $m^2/cm^3$ or less. However, it is not preferable since the number of process is increased.

After the completion of the second milling process, the secondmilled powder is preferably heat-treated at 800 to 1200°C for improving dielectric properties. At below 800°C, dielectric properties of the powder may not be sufficiently improved, because of limited effect of reducing the lattice strain. At above 1200°C, on the other hand, the particles may be fired with each other to deteriorate powder fluidity.

The dielectric ceramic powder obtained by the present invention preferably has a specific surface area (SSA) of 9 $m^2/cm^3$ or less. As discussed earlier, specific surface area of the dielectric ceramic powder affects the lowest melt viscosity of the powder/organic resin material mixture. The substrate can be molded more easily as melt viscosity of the mixture decreases, i.e., as mixture fluidity increases. The inventors of the present invention have found that the lowest melt viscosity is preferably 500 Pa·s or less for production of the substrate. The lowest melt viscosity exceeds 500 Pa·s as specific surface area of the powder exceeds 9 $m^2/cm^3$, as demonstrated in EXAMPLE described later. Therefore, specific surface area of the dielectric ceramic powder of the present invention is preferably set at 9 $m^2/cm^3$ or less. The specific surface area is more preferably 8.5 $m^2/cm^3$ or less, furthermore preferably 8 $m^2/cm^3$ or less.

Specific surface area of the powder of the present invention is converted to the value per unit volume, estimated by the general formula (1) in consideration that the particles having different densities being compared with each other:

$$\text{SSA } (m^2/cm^3) = \text{SSA } (m^2/g) \times \rho (g/cm^3) \qquad (1)$$

wherein,

SSA ($m^2$/g): Particle specific surface area determined by the BET(Brunauer-Emmett-Teller) method
ρ : Particle density determined using a pycnometer

The dielectric ceramic powder obtained by the present invention preferably has a lattice strain of 0.2 or less. Lattice strain of the powder affects Q value of the composite material: Q value is low at below 300, when powder lattice strain exceeds 0.2. The dielectric ceramic powder of the present invention preferably has a lattice strain of 0.18 or less, more preferably 0.16 or less.

Lattice strain of the powder of the present invention is determined by the Hall method, that is, by the general formula (2):

$$\beta \cos\theta/\lambda = 2\eta \ (\sin\theta/\lambda) + K/D \qquad (2)$$

wherein,

β: integral width
θ: Bragg angle of diffraction line
η: lattice strain
D: crystallite size
K: Schrrer constant
λ: X-ray wavelength (CuK$\alpha_1$, 1.54056Å)

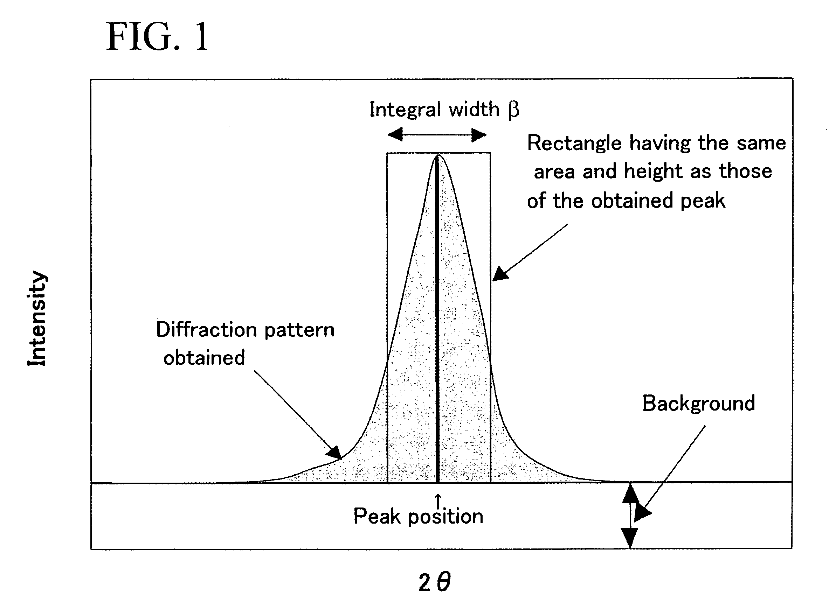

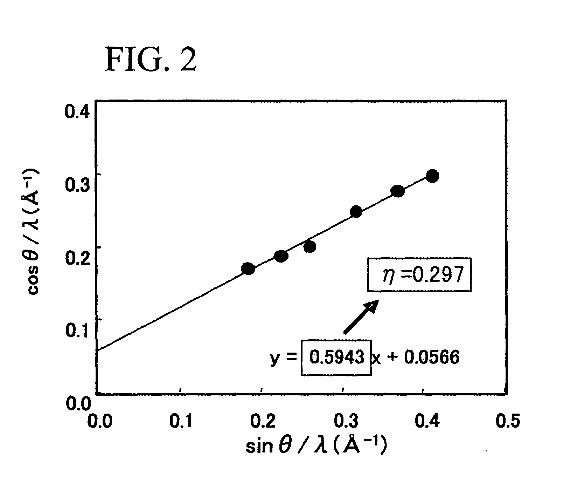

In the general formula (2), lattice strain η is determined by finding the peak position (2θ) and integral width (β) of the peak from the powder X-ray diffraction pattern shown in FIG. 1, and dividing by 2 the slope of the straight line in the plot shown in FIG. 2.

The analyzer and measurement conditions for obtaining the lattice strain in the present invention are summarized below:

Analyzer: RINT 2500 (manufactured by Rigaku Mechatronics),
Current-voltage: 50 kV-300 mA,
2θ: 20 to 85°,
Scanning rate: 1°/minute,
Sampling interval: 0.002°,
Divergence slit: 1/2°,
Scattering slit: 1/2°, and
Receiving slit: Open

The dielectric ceramic powder obtained by the present invention preferably has the largest particle size of 10 μm or less. The particle having a size above 10 μm is too large for the powder/organic resin material composite substrate having a thickness of around 40μm or so. Therefore, it is set at 10 μm or less, more preferably 8 μm or less, still more preferably 6 μm or less.

The ceramics for the dielectric ceramic powder of the present invention include those based on barium titanate, strontium titanate, calcium titanate, lead titanate, bismuth titanate, barium titanate-tin, lead-calcium, alumina, Ba-rare earth element-Ti (Ba-Nd-Ti, Ba-Sm-Ti), titanium dioxide, $CaWO_4$, and magnesium titanate.

Moreover, the ceramics based on Ba (Mg, Nb) $O_3$, Ba (Mg, Ta) $O_3$, Ba(Co, Mg, Nb)$O_3$ and Ba(Co, Mg, Ta)$O_3$ can also be applied.

The dielectric ceramic of the present invention is preferably of a composite perovskite, in particular of (Ba, Sr) -, (Ba, Ca) -, (Sr, Ca) $TiO_3$- or (Ba, Sr, Ca) $TiO_3$-based ceramic, because it gives a higher dielectric constant (ε) than other compositions. This preferable dielectric ceramic can contain one or more additives selected from oxides of A (A is one or two elements selected from Mn and Cr), oxides of X (X is one or more elements selected from V, Nb, W, Ta and Mo), oxides of R (R is one or more elements selected from Sc, Y, La, Ce, Pr, Nd, Pm, Sm, Eu, Gd, Tb, Dy, Ho, Er, Tm, Yb and Lu), $SiO_2$, MO (M is one or more elements selected from Ba, Ca, Sr and Mg), $Li_2O$, $B_2O_3$ and $MSiO_3$.

It is preferable that the retention temperature in the first firing of the above described dielectric ceramics is set approximately within the following ranges.

From 1250 to 1450°C: the ceramics based on barium titanate, strontium titanate, calcium titanate, lead titanate, bismuth titanate, barium titanate-tin, lead-calcium, Ba-rare earth element-Ti (Ba-Nd-Ti, Ba-Sm-Ti), titanium dioxide, (Ba, Sr), (Ba, Ca), (Sr, Ca)$TiO_3$, (Ba, Sr, Ca)$TiO_3$.

From 1500 to 1650°C: the ceramics based on alumina, Ba (Mg, Nb)$O_3$, Ba(Mg, Ta)$O_3$, Ba(Co, Mg, Nb) $O_3$, Ba(Co, Mg, Ta)$O_3$.

Next, a composite dielectric material to which the present invention is applied will be explained.

A composite dielectric material can be obtained by mixing each of the dielectric ceramic powders obtained as described above with an organic resin material; the composite dielectric material of the present invention is preferably produced according to the following production method. At the beginning, a dielectric ceramic powder and an organic resin material are separately weighed to predetermined amounts, and then mixed together. For mixing, for example, a dry mixing can be applied by using a kneader or the like; however, it is preferable that the mixing is fully carried out in an organic solvent such as toluene and xylene by using a ball mill, a stirrer, or the like. In this mixing, the flexibility providing agents, coupling agents and reaction initiators as described below may be added. The slurry thus obtained is dried, for example, at 60 to 150°C to yield a precursor for the composite dielectric material composed of a mixture of the dielectric ceramic powder and the organic resin material. The precursor is press molded into a desired shape, for example, at 100 to 300°C. In this case, the precursor may remain to be a sheet or may be converted into powder. Moreover, when a thermosetting resin is used as the organic resin material, the molded material is subjected to a curing treatment, for example, at 100 to 250°C. In this curing, a reinforcing material to be described later may be involved.

In a composite dielectric material of the present invention, when the total content of a dielectric ceramic powder and an organic resin material is represented as 100 vol%, the content of the dielectric ceramic powder is preferably 30 to 70 vol%, both inclusive. When the content of the dielectric ceramic powder is smaller than 30 vol% (the content of the organic resin material exceeds 70 vol%), the dielectric constant ε is decreased. On the other hand, when the content of the dielectric ceramic powder exceeds 70 vol% (the content of the organic resin material is smaller than 30 vol%) , the fluidity is extremely degraded when press molded, so that no dense molded product can be obtained. As a result, there easily occurs decrease in strength, water invasion or the like, leading to degradation of the electric properties. As compared to the case where no dielectric ceramic powder is added, sometimes the Q value is largely decreased. Consequently, the content of the dielectric ceramic powder is preferably set to be 30 to 70 vol%, both inclusive. The more preferable content of the dielectric ceramic powder is 30 to 50 vol%, and the furthermore preferable content of the dielectric ceramic powder is 35 to 45 vol%.

The organic resin materials which can be used for the composite dielectric materialofthe present invention include at least one of thermosetting resins of polyolefin-based, unsaturated polyster, vinyl ester, polyimide, bismaleimide-triazine (cyanate ester), polyphenylene ether (oxide), fumarate, polybutadiene and vinyl benzyl resins; or at least one of thermoplastic resins of aromatic polyester, polyphenylene sulfide, polyethylene terephthalate, polyethylene sulfide, polyethyl ether ketone, polytetrafluoroethylene, polyallylate and graft resins. Moreover, a composite resin of at least one of the above thermosetting resins and at least one of the above thermoplastic resins may be used in combination.

Of the above described organic resin materials, vinyl benzyl-based resin is preferable. The polymerized material or the cured material of the vinyl benzyl-based resin itself has a low dielectric constant (the relative dielectric constant is $\varepsilon r \approx 2.6$ at 2 GHz) and a high Q value ($Q \approx 250$ and $\tan\delta \approx 0.04$ at 2 GHz) in a high frequency region, and moreover, is an organic polymer material which is excellent in insulation properties and heat resistance, has a high glass transition temperature (Tg) and a high thermal decomposition initiation temperature, and has a low water absorption coefficient.

To the composite dielectric material of the present invention, a flexibility providing agent may be added. When a thermosetting resin is used, the thermosetting resin in semi-cured, i.e., B-staged form is laminated to produce a laminated substrate by press molding, as the case may be. If flexibility is lacked in the B-staged condition, there are causedproblems including generation of cracking and fracture, lowering of handlability, exfoliation of the organic resin material in cutting operation, and the like. The flexibility providing agent can suppress such problems. As a flexibility providing agent, for example, a thermoplastic elastomer is used. A thermoplastic elastomer is a plastic material which needs no vulcanization processing and has rubber performance. Among such thermoplastic elastomers, as materials having satisfactory dielectric properties, there can be listed polybutadiene, styrene/polyolefin-based copolymer and the like. The compounding ratio concerned is preferably such that the weight ratio between the organic resin material and the flexibility providing agent is of the order of (95:5) to (70:30).

To the composite dielectric material of the present invention, a coupling agent may be added. The coupling agent is used for the purpose of modifying the surface of the dielectric ceramic powder. By use of the coupling agent, the adhesiveness in the interface between the dielectric ceramic powder and the organic resin is improved, and consequently there can be expected such effects as improvement of the dispersion properties of the dielectric ceramic powder in the organic resin material, improvement of the fluidity and strength of the composite dielectric material, and stabilization of the dielectric properties in a high temperature/high humidity environment. Examples of the coupling agent used in the present invention include coupling agents based on silane, titanium, and aluminum. The coupling agents may be used, according to need, each alone or in combinations of two or more thereof. The added amount of the coupling agent for the dielectric ceramic powder may be appropriately selected to fall within a range from 0.1 to 5 parts by weight in relation to 100 parts by weight of the dielectric ceramic powder; however, more specifically, a highest effect is obtained by a treatment in which a monolayer film of the coupling agent is formed on the surface of the dielectric ceramic powder.

In the composite dielectric material of the present invention, the polymerization and curing of the organic resin material can be carried out by means of the methods well known in the art; a reaction initiator as a curing agent can be added. As the reaction initiator, there can be listed well known radical reaction initiators such as benzoyl peroxide, methyl ethyl ketone peroxide, dicumyl peroxide, and t-butyl perbenzoate. The used amount of the reaction initiator is, for example, in the case of the vinyl benzyl-based resin, 0 to 10 parts by weight in relation to 100 parts by weight of the resin concerned. Additionally, when the aforementioned flexibility providing agent is used, use of such a peroxide as the reaction initiator makes the peroxide play a role of a crosslinking agent, leading to drastic improvement of the resistance to solvent.

A reinforcing material can be added to the composite dielectric material of the present invention. A reinforcing material is effective in improving the mechanical strength and the dimension stability, and hence usually a prescribed amount of a reinforcing material is added to the organic resin material in producing a circuit board.

As the reinforcing materials, there can be listed fibrous reinforcing materials or plate-like or granular non-fibrous reinforcing materials. Among the fibrous reinforcing materials, here can be listed inorganic fibers such as glass fiber, alumina fiber, aluminum borate fiber, ceramics fiber, silicon carbide fiber, asbestos fiber, gypsum fiber, brass fiber, stainless fiber, steel fiber, metal fibers, magnesium borate whisker or fiber thereof, potassium titanate whisher or fiber, zinc oxide whisker, boron whisker fiber, and the like; and carbon fiber, aromatic polyamide fibers, aramide fibers, polyimide fibers, and the like. When a fibrous reinforcing material is used, there can be adopted a so-called impregnation method described in Japanese Patent Laid-Open No. 2001-187831. Namely, the point is that a fibrous reinforcing material molded in a sheet shape is immersed in a coating vessel in which the dielectric powder and the resin are mixed to prepare a slurry.

As the non-fibrous reinforcing materials, there can be listed needle-like, plate-like, or granular reinforcing materials which are silicates such as wollastonite, sericite, kaolin, mica, clay, bentonite, asbestos, talc, alumina silicate, pyrophyllite, montmorillonite, and the like; molybdenum disulfide, alumina, silicon chloride, zirconium oxide, iron oxides; carbonates such as calcium carbonate, magnesium carbonate, dolomite, and the like; sulfates such as calcium sulfate, barium sulfate, and the like; calcium polyphosphate, graphite, glass bead, glass microballoon, glass flake, boron nitride, silicon carbide, and silica. These materials may be hollow. When a non-fibrous reinforcing material is used, it only has to be added to an organic resin material.

These reinforcing materials may be used each alone, or can be used in combination with two or more than two kinds of materials thereof, and if need be, can be applied a pretreatment with coupling agents based on silane or titanium. A particularly preferable reinforcing material is glass fiber. As for the type of glass fiber, there is no particular limitation to it, and there can be used those which are generally used in reinforcing organic resin materials. The glass fiber to be used can be selected from, for example, chopped strands of long fiber type and short fiber type, chopped strand mat, continuous long fiber mat, cloth-like glass such as fabric, knit fabric, or the like, and milled fiber.

The content of a reinforcing material in a composite dielectric material preferably falls in the range from 10 to 30 wt%, and more preferably from 15 to 25 wt%.

A composite dielectric material of the present invention can be used in a variety of shapes such as film, a molded body in bulk form or in a prescribed shape, a film lamination, or the like. Accordingly, it can be used in electronic equipments and electronic parts for use in the high frequency region. In addition, they can be used for on-board substrates for CPU.

A composite dielectric material of the present invention and a board using thereof can be used suitably in the GHz band, and can have a dielectric constant $\varepsilon$ of 11.5 or more and a Q value of 350 or more in the case of the 2 GHz band.

EXAMPLE 1

Examples of the present invention are described below.

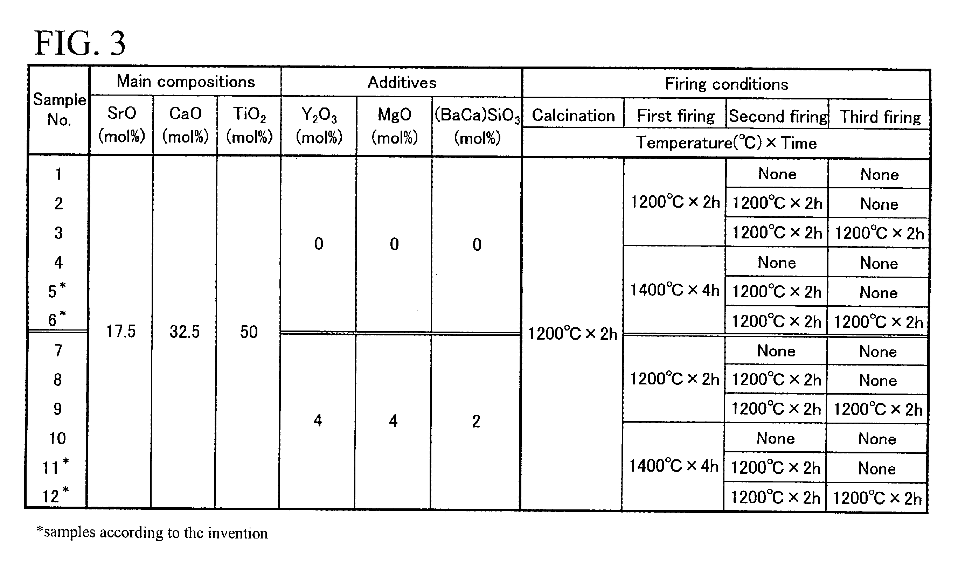

$SrCO_3$, $CaCO_3$ and $TiO_2$ powders were prepared, and weighed to be the base components of the fired substances shown in FIG. 3. These weighed powders were treated by wet ball-milling for 16 hours to prepare the mixtures of raw materials. The mixtures were calcined by retaining the mixtures at 1200°C for 2 hours.

Next, the obtained calcined substances (part of the substances were added with the additives shown in FIG. 3) were treated by wet ball-milling for 16 hours. The milled powders were subjected to the first firing under the conditions shown in FIG. 3, then preliminarily crushed in a mortar to pass through a mesh with 1 mm square openings, and then finely milled by a jet mill (the first milling) to obtain the first milled substances.

Next, the first milled substances were subjected to the second firing under the conditions shown in FIG. 3, then preliminarily crushed in a mortar to pass through a mesh with 1 mm square openings, and then finely milled by a jet mill (the second milling) to obtain the second milled substances.

Next, some of the second milled substances were subjected to the third firing under the conditions shown in FIG. 3, then preliminarily crushed in a mortar to pass through a mesh with 1 mm square openings, and then finely milled by a jet mill (the third milling) to obtain the third milled substances.

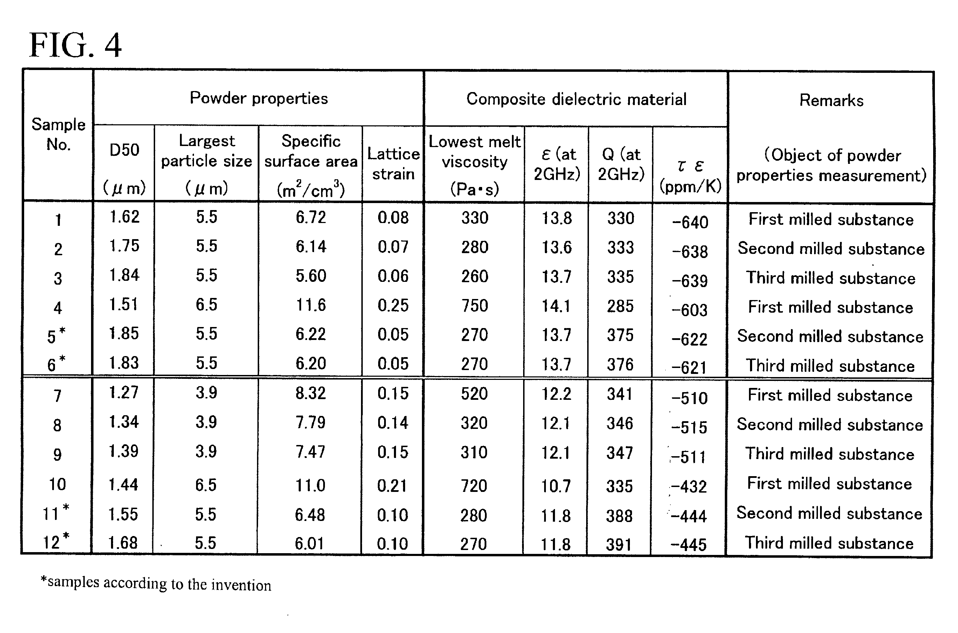

The dielectric ceramic powders prepared in EXAMPLE were analyzed for the powder properties shown in FIG. 4. Moreover, the product powders were incorporated with 40% by volume in relation to vinyl benzyl resin, to measure their lowest melt viscosity. The composite dielectric materials of the dielectric ceramic powders and vinyl benzyl resin were analyzed for dielectric constant ($\varepsilon$), Q value and temperature properties of the dielectric constant ($\tau\varepsilon$) at a frequency of 2 GHz. The results are summarized in FIG. 4.

Referring to the results of Nos. 1 to 6, shown in FIGS. 3 and 4, the following findings are obtained.

When the first firing was carried out at a temperature of 1200°C (Samples Nos. 1 to 3) or the second firing was carried out at a temperature of 1200°C although the first firing was carried out at a temperature of 1400°C (Samples Nos. 5 and 6), the obtained dielectric ceramic powders each were able to acquire a desired specific surface area of 9 $m^2/cm^3$ or less and a desired lattice strain of 0.2 or less. By contrast, when firing was restricted to the first firing at a temperature of 1400°C, the specific surface areas exceeded 9 $m^2/cm^3$ and the lattice strains exceeded 0.2; consequently, the lowest melt viscosity of Sample No. 4 reached up to 750 Pa·s.

A comparison of Samples Nos. 1 to 3 with Sample Nos. 5 and 6, all of these having a desired specific surface area and a desired lattice strain, reveals that Samples No. 5 and 6 in which the first firing was carried out at 1400°C and then the second firing was carried out at 1200°C each are excellent in Q value and in temperature properties of the dielectric constant ($\tau\varepsilon$) as a composite dielectric material.

Samples Nos. 7 to 12 in FIGS. 3 and 4 were obtained separately by adding the additives shown in FIG. 3 to Samples Nos. 1 to 6, and showed the tendencies similar to those in Samples Nos. 1 to 6. It may be noted that addition of the additives was able to improve the Q value and the temperature properties of the dielectric constant ($\tau\varepsilon$).

As described above, it can be seen that by applying the present invention, there can be produced a composite dielectric material which can secure the fluidity of the dielectric ceramic powder in the composite dielectric material and is excellent in dielectric properties.

**Claims**

1. A method for producing a dielectric ceramic powder, comprising:

a first firing step for firing a starting material by retaining said starting material at a first temperature to obtain a first fired substance;

a first milling step formilling said first fired substance to obtain a first milled substance;

a second firing step for firing said first milled substance by retaining said first milled substance at a second temperature lower than said first temperature to obtain a second fired substance; and

a second milling step for milling said second fired substance to obtain a second milled substance.

2. The method for producing a dielectric ceramic powder according to claim 1, wherein:

said first temperature in said first firing step is 1300 to 1650°C, and said second temperature in said second firing step is 1100 to 1300°C.

3. The method for producing a dielectric ceramic powder according to claim 1, wherein:

the difference between said first temperature and said second temperature is 100°C or greater.

4. The method for producing a dielectric ceramic powder according to claim 1, wherein:

the retention time in said second firing step is shorter than that in said first firing step.

5. The method for producing a dielectric ceramic powder according to claim 1, wherein:

said second milled substance obtained by said second milling step has the largest particle size of 10 μm or less.

6. The method for producing a dielectric ceramic powder according to claim 5, wherein:

said second milled substance obtained by said second milling step has the largest particle size of 8 μm or less.

7. The method for producing a dielectric ceramic powder according to claim 1, wherein:

a jet mill is used in said first milling step and said second milling step.

8. The method for producing a dielectric ceramic powder according to claim 1, wherein:

said dielectric ceramic powder is a composite perovskite ceramic powder.

9. The method for producing a dielectric ceramic powder according to claim 8, wherein:

said composite perovskite ceramic powder is at least one of (Ba, Sr)-based ceramic, (Ba, Ca)-based ceramic, (Sr, Ca)TiO$_3$-based ceramic and (Ba, Sr, Ca)TiO$_3$-based ceramic.

10. The method for producing a dielectric ceramic powder according to claim 9, wherein:

said first temperature in said first firing step is 1250 to 1450°C, and said second temperature in said second firing step is 1100 to 1300°C.

11. The method for producing a dielectric ceramic powder according to claim 1, wherein:

said starting material is a calcined substance obtained by calcining a mixture of raw material powders.

12. A method for producing a composite dielectric material comprising a dielectric ceramic powder and an organic resin material for holding said dielectric ceramic powder therein, wherein:

said dielectric ceramic powder is produced through:

a first firing step for firing a starting material by retaining said starting material at a first temperature to obtain a first fired substance;

a first milling step for milling said first fired substance to obtain a first milled substance;

a second firing step for firing said first milled substance by retaining said first milled substance at a second temperature lower than said first temperature to obtain a second fired substance; and

a second milling step for milling said second fired substance to obtain a second milled substance.

13. The method for producing a composite dielectric material according to claim 12, further comprising:

a mixing step for mixing said dielectric ceramic powder with said organic resin material.

14. The method for producing a composite dielectric material according to claim 12, wherein:

said first temperature in said first firing step is 1300 to 1650°C, and said second temperature in said second firing step is 1100 to 1300°C.

**15.** The method for producing a composite dielectric material according to claim 12, wherein:

a jet mill is used in said first milling step and said second milling step.

# FIG. 1

Integral width β

Rectangle having the same area and height as those of the obtained peak

Diffraction pattern obtained

Background

Peak position

Intensity

2θ

## FIG. 2

# FIG. 3

| Sample No. | Main compositions | | | Additives | | | Firing conditions | | | |
|---|---|---|---|---|---|---|---|---|---|---|
| | SrO (mol%) | CaO (mol%) | $TiO_2$ (mol%) | $Y_2O_3$ (mol%) | MgO (mol%) | $(BaCa)SiO_3$ (mol%) | Calcination | First firing | Second firing | Third firing |
| | | | | | | | Temperature(°C) × Time | | | |
| 1 | 17.5 | 32.5 | 50 | 0 | 0 | 0 | 1200°C × 2h | 1200°C × 2h | None | None |
| 2 | | | | | | | | | 1200°C × 2h | None |
| 3 | | | | | | | | | 1200°C × 2h | 1200°C × 2h |
| 4 | | | | | | | | 1400°C × 4h | None | None |
| 5 * | | | | | | | | | 1200°C × 2h | None |
| 6 * | | | | | | | | | 1200°C × 2h | 1200°C × 2h |
| 7 | | | | 4 | 4 | 2 | | 1200°C × 2h | None | None |
| 8 | | | | | | | | | 1200°C × 2h | None |
| 9 | | | | | | | | | 1200°C × 2h | 1200°C × 2h |
| 10 | | | | | | | | 1400°C × 4h | None | None |
| 11 * | | | | | | | | | 1200°C × 2h | None |
| 12 * | | | | | | | | | 1200°C × 2h | 1200°C × 2h |

*samples according to the invention

EP 1 589 065 A1

# FIG. 4

| Sample No. | Powder properties | | | | Composite dielectric material | | | | Remarks |
|---|---|---|---|---|---|---|---|---|---|
| | D50 ($\mu$m) | Largest particle size ($\mu$m) | Specific surface area (m$^2$/cm$^3$) | Lattice strain | Lowest melt viscosity (Pa·s) | $\varepsilon$ (at 2GHz) | Q (at 2GHz) | $\tau$ $\varepsilon$ (ppm/K) | (Object of powder properties measurement) |
| 1 | 1.62 | 5.5 | 6.72 | 0.08 | 330 | 13.8 | 330 | −640 | First milled substance |
| 2 | 1.75 | 5.5 | 6.14 | 0.07 | 280 | 13.6 | 333 | −638 | Second milled substance |
| 3 | 1.84 | 5.5 | 5.60 | 0.06 | 260 | 13.7 | 335 | −639 | Third milled substance |
| 4 | 1.51 | 6.5 | 11.6 | 0.25 | 750 | 14.1 | 285 | −603 | First milled substance |
| 5* | 1.85 | 5.5 | 6.22 | 0.05 | 270 | 13.7 | 375 | −622 | Second milled substance |
| 6* | 1.83 | 5.5 | 6.20 | 0.05 | 270 | 13.7 | 376 | −621 | Third milled substance |
| 7 | 1.27 | 3.9 | 8.32 | 0.15 | 520 | 12.2 | 341 | −510 | First milled substance |
| 8 | 1.34 | 3.9 | 7.79 | 0.14 | 320 | 12.1 | 346 | −515 | Second milled substance |
| 9 | 1.39 | 3.9 | 7.47 | 0.15 | 310 | 12.1 | 347 | −511 | Third milled substance |
| 10 | 1.44 | 6.5 | 11.0 | 0.21 | 720 | 10.7 | 335 | −432 | First milled substance |
| 11* | 1.55 | 5.5 | 6.48 | 0.10 | 280 | 11.8 | 388 | −444 | Second milled substance |
| 12* | 1.68 | 5.5 | 6.01 | 0.10 | 270 | 11.8 | 391 | −445 | Third milled substance |

*samples according to the invention

EP 1 589 065 A1

**European Patent Office**

## EUROPEAN SEARCH REPORT

Application Number

EP 05 00 8752

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 555 958 B1 (SRIVASTAVA ALOK MANI ET AL) 29 April 2003 (2003-04-29) * example 1 * ----- | 1-4 | C08K3/22 H01B3/00 H05K1/03 |
| D,A | PATENT ABSTRACTS OF JAPAN vol. 2003, no. 09, 3 September 2003 (2003-09-03) -& JP 2003 151352 A (TDK CORP), 23 May 2003 (2003-05-23) * the whole document * ----- | 1-15 | |

| TECHNICAL FIELDS SEARCHED (Int.Cl.7) |
|---|
| C08K H01B H05K C04B C01B |

The present search report has been drawn up for all claims

| Place of search | Date of completion of the search | Examiner |
|---|---|---|
| Munich | 8 June 2005 | Munro, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................
& : member of the same patent family, corresponding document

EPO FORM 1503 03.82 (P04C01)

EP 1 589 065 A1

## ANNEX TO THE EUROPEAN SEARCH REPORT
## ON EUROPEAN PATENT APPLICATION NO.

EP 05 00 8752

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2005

| Patent document cited in search report | | Publication date | Patent family member(s) | | Publication date |
|---|---|---|---|---|---|
| US 6555958 | B1 | 29-04-2003 | NONE | | |
| JP 2003151352 | A | 23-05-2003 | CN | 1464863 A | 31-12-2003 |
| | | | EP | 1422196 A1 | 26-05-2004 |
| | | | WO | 03010092 A1 | 06-02-2003 |
| | | | US | 2004180991 A1 | 16-09-2004 |

EPO FORM P0459

For more details about this annex : see Official Journal of the European Patent Office, No. 12/82

16